# EUROPEAN PATENT APPLICATION

(11) **EP 4 742 225 A1**
(43) Date of publication of application: **13.05.2026**
(21) Application number: 24842053.1
(22) Date of filing: 21.05.2024
(51) Int. Cl.: G09G 3/20

(54) **GOA DRIVING CIRCUIT, DISPLAY PANEL AND DISPLAY APPARATUS**

(30) Priority: 14.07.2023 CN 202310863346
(71) Applicant: HKC CORPORATION LIMITED, Shenzhen, Guangdong 518000 (CN)
(72) Inventor: CHEN, Chen, Shenzhen, Guangdong 518000 (CN); YUAN, Xin, Shenzhen, Guangdong 518000 (CN); ZHOU, Xiufeng, Shenzhen, Guangdong 518000 (CN); XIE, Junfeng, Shenzhen, Guangdong 518000 (CN)
(74) Representative: dompatent
(86) International application number: PCT/CN2024/094452
(87) International publication number: WO 2025/016053

(57) **Abstract**

A GOA driving circuit (100), a display panel (1) and a display device. The GOA driving circuit (100) includes multiple cascaded GOA units (110), each GOA unit (110) includes a trigger circuit (10), an inverter circuit (20), a pull-up circuit (30) and a pull-down circuit (40). The inverter circuit (20) includes a first thin film transistor (T1) and a second thin film transistor (T2). When a first clock signal (CKL) is at a high level, the trigger circuit (10) and the first thin film transistor (T1) are switched on. When an output of the trigger circuit (10) is at a high level, voltages at two ends of the second thin film transistor (T2) are both at a high level and a through current of the second thin film transistor (T2) is small. When the first clock signal (CKL) is at a low level, the first thin film transistor (T1) is switched off, then the second thin film transistor (T2) is also unable to form the through current.

## Description

This application claims the priority of the Chinese Patent Application No. 202310863346.3, entitled "GOA Driving Circuit, Display Panel and Display Device" filed with the Chinese Patent Office on July 14, 2023, and the entire content of which is incorporated herein by reference.

### TECHNICAL FIELD

The present application relates to the field of display panel technology, more particularly to a GOA driving circuit, a display panel and a display device.

### BACKGROUND

GOA (Gate Driver on Array, gate driver on array substrate) technology integrates the GOA driving circuit" TFT (Thin Film Transistor, thin film field-effect transistor) on an array substrate, thereby the gate driving integrated circuit part originally arranged outside the array substrate is eliminated, and thus the cost of the product is reduced from both the material cost and process steps aspects.

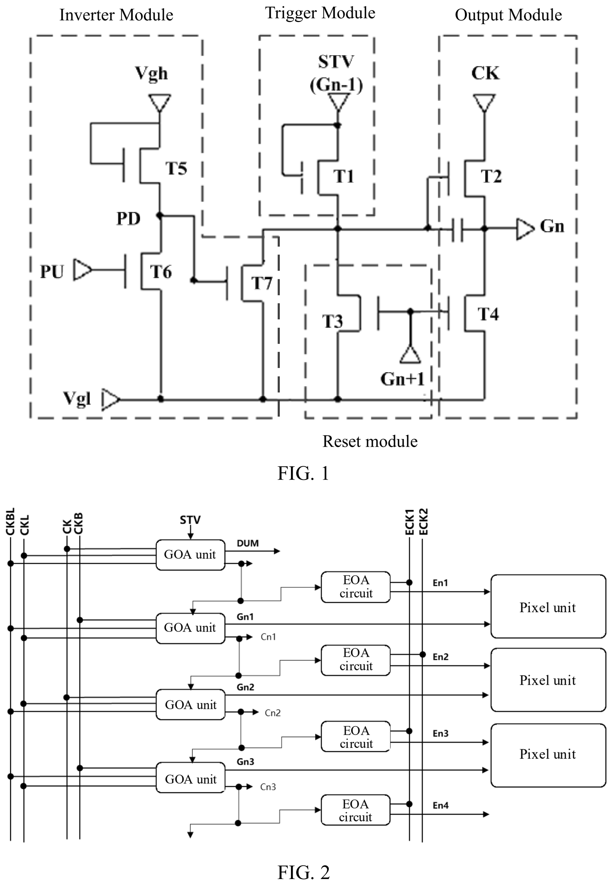

The GOA driving circuit usually includes multiple cascaded GOA units. The commonly-used GOA unit is shown in FIG. 1, which usually includes an inverter module, a reset module, a trigger module and an output module. The inverter module is used to achieve an inversion conversion from a pull-up control signal PU to a pull-down control signal PD. However, in the inverter module, T6 is switched on to pull PD node down when PU is set high, at this time, T5 is in an on state, which will cause a through-conduction current between Vgh and Vgl, resulting in an abnormal GOA unit, and then causing an abnormal display on the display panel.

### SUMMARY

### TECHNICAL PROBLEM

An objective of the present application is to provide a GOA driving circuit, which aims to address the problem of display panel display abnormalities caused by the through-conduction current in the inverter module of traditional GOA units.

### TECHNICAL SOLUTIONS

To solve the above technical problem, technical solutions adopted by the embodiments of the present application are as follows:

In accordance with a first aspect of the embodiments of the present application, a GOA driving circuit is provided, which includes multiple cascaded GOA units, and each GOA unit includes:
a trigger circuit, an input end of the trigger circuit is configured to receive a start signal or an output signal of a GOA unit at a previous stage, a control end of the trigger circuit is configured to receive a first clock signal, the trigger circuit is triggered to switch on and output the start signal or the output signal when the first clock signal is at a high level, and is triggered to switch off when the first clock signal is at a low level;
a pull-up circuit, an input end of the pull-up circuit is configured to receive a second clock signal, an output end of the pull-up circuit serves as a signal output end of the GOA unit, a control end of the pull-up circuit is in connection with an output end of the trigger circuit, the pull-up circuit is triggered by the start signal or the output signal to switch on and output the second clock signal;
an inverter circuit which includes a first thin film transistor and a second thin film transistor, a first end of the first thin film transistor is connected to a positive power supply terminal, a control end of the first thin film transistor and a second end of the second thin film transistor are configured to receive the first clock signal, a second end of the first thin film transistor and a first end of the second thin film transistor are connected in common to constitute an output end of the inverter circuit, a control end of the second thin film transistor is in connection with an output end of the trigger circuit, the first thin film transistor and the second thin film transistor are triggered by a high-level signal to switch on and triggered by a low-level signal to switch off; and
a pull-down circuit, an input end of the pull-down circuit is configured to receive a first line switch-off signal, an output end of the pull-down circuit is in connection with the output end of the pull-up circuit, a control end of the pull-down circuit is in connection with the output end of the inverter circuit, and the pull-down circuit is triggered by a high-level signal to switch on.

Optionally, the GOA units at multiple stages are respectively connected to corresponding scan lines of an array substrate, and the scan lines at multiple stages are connected to the multiple rows of pixel units on the array substrate, and the GOA units at multiple stages output row-on signals and row-off signals to the multiple rows of pixel units row by row.

Optionally, the first thin film transistor and the second thin film transistor are N-channel thin film transistors.

Optionally, the trigger circuit includes a third thin film transistor and a fourth thin film transistor.

A first end of the third thin film transistor serves as the input end of the trigger circuit, a second end of the third thin film transistor is in connection with a first end of the fourth thin film transistor, a second end of the fourth thin film transistor serves as the output end of the trigger circuit, and a control end of the third thin film transistor and a control end of the fourth thin film transistor are connected in common to constitute the control end of the trigger circuit.

Optionally, the GOA driving circuit also includes a reset circuit.

The reset circuit is in connection with the output end of the trigger circuit, and triggered by a reset control signal to reset each circuit of the GOA unit.

The reset circuit includes a fifth thin film transistor and a sixth thin film transistor.

A first end of the fifth thin film transistor is configured to receive a second line switch-off signal, a second end of the fifth thin film transistor and a first end of the sixth thin film transistor are connected in common, a second end of the sixth thin film transistor serves as an output end of the reset circuit, and a control end of the fifth thin film transistor and a control end of the sixth thin film transistor are connected in common to receive the reset control signal.

Optionally, the first line switch-off signal and the second line switch-off signal are low-level signals.

Optionally, the GOA driving circuit also includes a stage transfer circuit and a bootstrap capacitor.

An input end of the stage transfer circuit is configured to receive a third clock signal that is inverted from the first clock signal, an output end of the stage transfer circuit is in connection with the input end of the trigger circuit of a GOA unit at a next stage, and the stage transfer circuit is triggered by the start signal or the output signal to switch on and output the third clock signal.

The bootstrap capacitor is connected in parallel between the output end and the control end of the stage transfer circuit.

Optionally, the stage transfer circuit includes a seventh thin film transistor, an eighth thin film transistor and a ninth thin film transistor.

A first end of the seventh thin film transistor and a first end of the ninth thin film transistor are connected in common to constitute the input end of the stage transfer circuit, a second end of the seventh thin film transistor, a first end of the eighth thin film transistor, a control end of the ninth thin film transistor and a first end of the bootstrap capacitor are connected in common to constitute the output end of the stage transfer circuit, a control end of the seventh thin film transistor, a second end of the bootstrap capacitor and an output end of the trigger circuit are connected in common, a control end of the eighth thin film transistor is in connection with the output end of the inverter circuit, a second end of the eighth thin film transistor is configured to receive the first line switch-off signal.

Optionally, the pull-up circuit includes a tenth thin film transistor, a first end, a second end and a control end of the tenth thin film transistor respectively serve as the input end, the output end and the control end of the pull-up circuit.

The pull-down circuit includes an eleventh thin film transistor, a first end, a second end and a control end of the eleventh thin film transistor respectively serve as the input end, the output end and the control end of the pull-down circuit.

Optionally, the pull-down circuit also includes a twelfth thin film transistor, a thirteenth thin film transistor and a coupling capacitor.

A first end of the coupling capacitor is configured to receive the third clock signal, a second end of the coupling capacitor, a control end of the twelfth thin film transistor and a first end of the thirteenth thin film transistor are connected in common, a first end and a second end of the twelfth thin film transistor are respectively connected in parallel to the first end and the second end of the eleventh thin film transistor, a control end of the thirteenth thin film transistor is in connection with the output end of the stage transfer circuit, and a second end of the thirteenth thin film transistor is configured to receive the second line switch-off signal.

Optionally, the stage transfer circuit also includes a fourteenth thin film transistor and a fifteenth thin film transistor.

A control end of the fourteenth thin film transistor is in connection with a second end of the coupling capacitor, a first end and a second end of the fourteenth thin film transistor are respectively connected in parallel to the first end and the second end of the eighth thin film transistor, a first end of the fifteenth thin film transistor is in connection with the output end of the inverter circuit, a second end of the fifteenth thin film transistor is configured to receive the second line switch-off signal, and a control end of the fifteenth thin film transistor is configured to receive the third clock signal.

Optionally, during a period when the stage transfer circuit and the pull-down circuit continuously output low-level signals, the eighth thin film transistor and the fourteenth thin film transistor are alternately switched on and off, and the eleventh thin film transistor and the twelfth thin film transistor are alternately switched on and off.

In accordance with a second aspect of the embodiments of the present application, a display panel is provided, which includes an array substrate and the GOA driving circuit as described above, and the GOA driving circuit is arranged on one side or both sides of the array substrate.

In accordance with a third aspect of the embodiment of the present application, a display device is provided, which includes a backlight module, a drive circuit board and the display panel as described above, the backlight module and the display panel are arranged opposite to each other, and the drive circuit board is electrically connected to the display panel.

Optionally, the backlight module is configured to provide backlight, the drive circuit board is connected to the display panel through a chip-on-chip film, and an external control signal is input to a driving chip in the chip-on-chip film, and the driving chip converts the external control signal into a data signal and a control signal required for driving the GOA driving circuit.

### BENEFICIAL EFFECTS

The GOA driving circuit provided in the first aspect of the embodiments of the present application include multiple cascaded GOA units, each GOA unit includes a trigger circuit, an inverter circuit, a pull-up circuit and a pull-down circuit. The inverter circuit includes a first thin film transistor and a second thin film transistor. The trigger circuit and the first thin film transistor are switched on when the first clock signal is at a high level. In case that the trigger circuit outputs a high level, voltages at two ends of the second thin film transistor are both at a high level, thus a through current of the second thin film transistor is small, and in case that the first clock signal is at a low level, the first thin film transistor is switched off, then the second thin film transistor is also unable to form the through current, which improves the operational reliability of the GOA unit, thereby the display reliability of the display panel is further enhanced.

It can be understood that, for the beneficial effects of the second and third aspects mentioned above, references may be made to the relevant description in the first aspect mentioned above, which will not be repeated here.

### DESCRIPTION OF DRAWINGS

To illustrate the technical solutions in the embodiments of the present application more clearly, the drawings required for use in the descriptions of the embodiments or existing technologies will be briefly introduced below. Obviously, the drawings described below are merely some embodiments of the present application. For ordinary technicians in this field, other drawings may be obtained based on these drawings without paying creative efforts.
FIG. 1 is a schematic diagram of a circuit for a conventional GOA unit;
FIG. 2 is a schematic diagram of a structure for a GOA driving circuit provided in Embodiment 1 of the present application;
FIG. 3 is a schematic diagram of a first structure for a GOA unit provided in Embodiment 1 of the present application;
FIG. 4 is a schematic diagram of a second structure for the GOA unit provided in Embodiment 1 of the present application;
FIG. 5 is a schematic diagram of a circuit for the GOA unit provided in Embodiment 2 of the present application;
FIG. 6 is a schematic diagram of a structure for the GOA unit provided in Embodiment 3 of the present application;
FIG. 7 is a schematic diagram of a circuit for the GOA unit provided in Embodiment 3 of the present application;
FIG. 8 is a schematic diagram of a signal timing for the GOA unit provided in Embodiment 3 of the present application;
FIG. 9 is a schematic diagram of a waveform for a GPD node provided in Embodiment 4 of the present application. Intention;
FIG. 10 is a schematic diagram showing variations of current and voltage in a thin film transistor provided in Embodiment 4 of the present application;
FIG. 11 is a schematic diagram of a circuit for the GOA unit in Embodiment 4 of the present application;
FIG. 12 is a schematic diagram of a signal timing for the GOA unit provided in Embodiment 4 of the present application;
FIG. 13 is a schematic diagram of a first structure for the thin film transistor provided in Embodiment 4 of the present application;
FIG. 14 is a schematic diagram of a second structure for the thin film transistor provided in Embodiment 4 of the present application;
FIG. 15 is a schematic diagram of a third structure for the thin film transistor provided in Embodiment 4 of the present application;
FIG. 16 is a schematic diagram of a structure for a display panel provided in Embodiment 5 of the present application; and
FIG. 17 is a schematic diagram of a structure for a display device provided in Embodiment 6 of the present application.

In the figures, reference numerals are listed as follows:
1, display panel; 2, drive circuit board; 3, backlight module; 100, GOA driving circuit; 200, array substrate; 110, GOA unit; 10, trigger circuit; 20, inverter circuit; 30, pull-up circuit; 40, pull-down circuit; 50, reset circuit; 60, stage transfer circuit; 11, substrate; 12, buffer layer; 13, active layer; 14, gate insulating layer; 15, top gate layer; 16, interlayer insulating layer; 171, source; 172, drain; 18, bottom gate layer;
T1, first thin film transistor; T2, second thin film transistor; T3, third thin film transistor; T4, fourth thin film transistor; T5, fifth thin film transistor; T6, sixth thin film transistor; T7, seventh thin film transistor; T8, eighth thin film transistor; T9, ninth thin film transistor; T10, tenth thin film transistor; T11, eleventh thin film transistor; T12, twelfth thin film transistor; T13, thirteenth thin film transistor; T14, fourteenth thin film transistor; T15, fifteenth thin film transistor; C1, bootstrap capacitor; C2, coupling capacitor; and
STV, start signal; Cn1, first cascade signal; Cn2, second cascade signal; Cn3, third cascade signal; Gn1, first scan signal; Gn2, second scan signal; Gn3, third scan signal; Cn-1, cascade signal of a GOA unit at a previous stage; CKL, first clock signal; CKBL, third clock signal; CK, second clock signal; CKB, fourth clock signal; ECK1, fifth clock signal; ECK2, sixth clock signal; VDD, positive power supply signal; RST, reset control signal; Cn, cascade signal of a GOA unit at a current stage; Gn, scan signal of the GOA unit at the current stage; VGL1, first line switch-off signal; VGL2, second line switch-off signal; GPU, output signal of the trigger circuit; GPD, output signal of the inverter circuit, GPDB, coupling signal.

### DETAILED DESCRIPTION OF EMBODIMENTS

To explain the technical problems to be solved, technical solutions and beneficial effects of the present application more explicitly and clearer, the present application is further described in detail in conjunction with the accompanying drawings and embodiments. It should be understood that the specific embodiments described herein are merely used to explain the present application and are not intended to limit the present application.

Furthermore, the terms "first" and "second" are used solely for descriptive purposes and should not be construed as indicating or implying relative importance or implicitly indicating the quantity of technical features indicated. Therefore, the feature defined as "first" and "second" may explicitly or implicitly include one or more of such features. In the description of the present application, the term "multiple" means two or more, unless otherwise clearly and specifically defined.

### Embodiment 1

In a first aspect of the embodiments of the present application, a GOA driving circuit 100 is provided, which includes multiple cascaded GOA units 110. The GOA units 110 at multiple stages are respectively connected to corresponding scan lines of an array substrate 200, and the scan lines at multiple stages are connected to multiple rows of pixel units on the array substrate 200. The GOA units 110 at multiple stages output line switch-on signals and line switch-off signals to the multiple rows of pixel units row by row, thereby the line scanning drive is achieved, and then a data signal input by a source driving circuit and a backlight source are combined to drive the pixel units to display corresponding image information.

Herein, the GOA unit 110 at each stage is used to receive a corresponding start signal STV, a clock signal, a line switch-off signal, a cascade signal output from a GOA unit 110 at a previous stage, etc., to trigger an output of a cascade signal Cn required by a GOA unit 110 at a next stage, for example, a first cascade signal Cn1, a second cascade signal Cn2, and a third cascade signal Cn3 are output in sequence, and simultaneously an output of the scan signal required by the pixel units at each stage is triggered, for example, a first scan signal Gn1 to a first row of pixel units, a second scan signal Gn2 to a second row of pixel units, and a third scan signal Gn3 to a third row of pixel units are output.

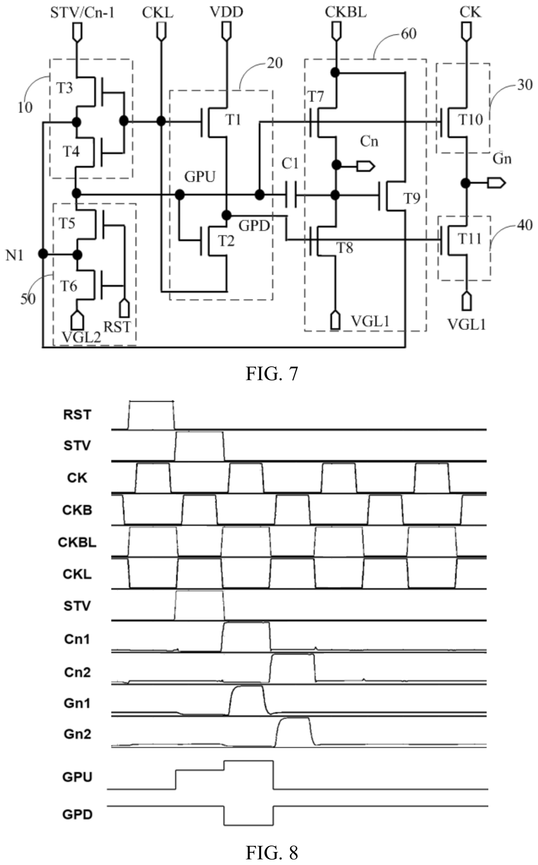

The clock signal may include a first clock signal CKL, a second clock signal CK, a third clock signal CKBL, and a fourth clock signal CKB. Herein, the scan signal Gn and the cascade signal Cn may be the same signal or different signals, and the specific type of these signals are not limited. The waveforms of adjacent cascade signals are the same and differ by a preset phase, and the waveforms of adjacent scan signals are the same and differ by a preset phase. The duration of the preset phase corresponds to the unit duration of a clock signal. For example, as shown in FIG. 8, the first cascade signal Cn1 differs from the second cascade signal Cn2 by the unit duration of a clock signal, and the first scan signal Gn1 differs from the second scan signal Gn2 by the unit duration of a clock signal.

Herein, as shown in FIG. 2, the GOA driving circuit 100 may also include an end of array (EOA) circuit which includes multiple EOA units. Herein, the GOA unit 110, under the drive of the fifth clock signal ECK1 and the sixth clock signal ECK2 and the scan signal corresponding to the GOA unit 110, outputs a high level in a data input phase, outputs a low level in other phases, and the EOA unit outputs a low level in the data input phase and a high level in other phases, that is, in the data input phase, the EOA unit is in a cut-off state and does not output a signal. Herein, the EOA unit may be composed of an nT1C structure, such as a 4T1C, 8T1C, or other structures.

To address the shoot-through current issue in the inverter circuit, each GOA unit 110 in this embodiment includes: a trigger circuit 10, a pull-up circuit 30, a pull-down circuit 40 and an inverter circuit 20.

An input end of the trigger circuit 10 is configured to receive either the start signals STV or an output signal from the GOA unit 110 at the previous stage. A control end of the trigger circuit 10 is configured to receive the first clock signal CKL. The trigger circuit 10 is triggered to switch on and output either the start signals STV or the output signal when the first clock signal CKL is at a high level, and is triggered to switch off when the first clock signal CKL is at a low level.

An input end of the pull-up circuit 30 is configured to receive the second clock signal CK, and an output end of the pull-up circuit 30 serves as a signal output end of the GOA unit 110. A control end of the pull-up circuit 30 is in connection with an output end of the trigger circuit 10. The pull-up circuit 30 is triggered by the start signal STV or the output signal to switch on and output the second clock signal CK.

The inverter circuit 20 includes a first thin film transistor T1 and a second thin film transistor T2. A first end of the first thin film transistor T1 is connected to a positive power supply terminal, a control end of the first thin film transistor T1 and a second end of the second thin film transistor T2 are configured to receive the first clock signal CKL. A second end of the first thin film transistor T1 and a first end of the second thin film transistor T2 are connected in common to constitute an output end of the inverter circuit 20, the control end of the second thin film transistor T2 is in connection with the output end of the trigger circuit 10, the first thin film transistor T1 and the second thin film transistor T2 are triggered to switch on when a high-level signal is applied and triggered to switch off when a low-level signal is applied.

An input end of the pull-down circuit 40 is configured to receive a first line switch-off signal VGL1, an output end of the pull-down circuit 40 and the output end of the pull-up circuit 30 are common in common, a control end of the pull-down circuit 40 is in connection with the output end of the inverter circuit 20, and the pull-down circuit 40 is triggered to switch on when a high-level signal is applied.

In this embodiment, the output end of the trigger circuit 10 is defined as the GPU node, and the output signal of the trigger circuit 10 is designated as GPU. The output end of the inverter circuit 20 is defined as the GPD node, and the output signal of the inverter circuit 20 is designated as GPD, the high and low levels of the GPU node are configured to control the on and off of the pull-up circuit 30, the high and low levels of the GPD node are configured to control the on and off of the pull-down circuit 40, and the inverter circuit 20 is configured to receive a signal of the GPU node, and output a signal of the GPD node according to corresponding level states of the first clock signal CKL, a positive power supply signal of the positive power supply terminal VDD and the signal of the GPU node.

The first thin film transistor T1 and the second thin film transistor T2 are N-channel thin film transistors, and are triggered to switch on when a high level is received, and triggered to switch off when a low level is received.

Herein, when the start signal STV or the output signal of the GOA unit 110 at the previous stage is written into a trigger waveform, the output signal of the GOA unit 110 at the previous stage may be either a scan signal Gn-1 output to the pixel units or a cascade signal Cn-1. At this time, the first clock signal CKL is at a high level, the trigger circuit 10 and the first thin film transistor T1 are switched on, the start signal STV or the output signal of the GOA unit 110 at the previous stage is output through the trigger circuit 10, the signal of the GPU node is at a high level, the high-level signal is output to the pull-up circuit 30, then the pull-up circuit 30 is triggered to switch on output the second clock signal CK. The second clock signal CK is output as the output signal of the GOA unit 110 at the current stage to the GOA unit 110 at the next stage and the corresponding row of pixel units at the current stage. At this time, the voltages at two ends of the second thin film transistor T2 are both at a high level, and the through current of the second thin film transistor T2 is small.

Then, the first clock signal CKL is switched to a low level, the trigger circuit 10 and the first thin film transistor T1 are switched off, and the pull-up circuit 30 is switched off. At this time, since the first thin film transistor T1 is switched off, the second thin film transistor T2 cannot form a through current, which improves the operational reliability of the GOA unit 110, thereby the display reliability of the display panel 1 is further enhanced.

When the first clock signal CKL is switched to a high level again, since the start signal STV or the output signal of the GOA unit 110 at the previous stage is written into a low-level signal, at this time, the pull-up circuit 30 is switched off, the first thin film transistor T1 is switched on, the second thin film transistor T2 is switched off, the signa at the GPD node is switched to a high level of the positive power supply signal VDD, the pull-down circuit 40 is switched on, and the GOA unit 110 continuously outputs the first line switch-off signal VGL1. Herein, the first line switch-off signal VGL1 is a low-level signal.

By adjusting the structure of the inverter circuit 20, the through current of the inverter circuit is improved, thereby the operational reliability of the GOA unit 110 and the display reliability of the display panel 1 are enhanced.

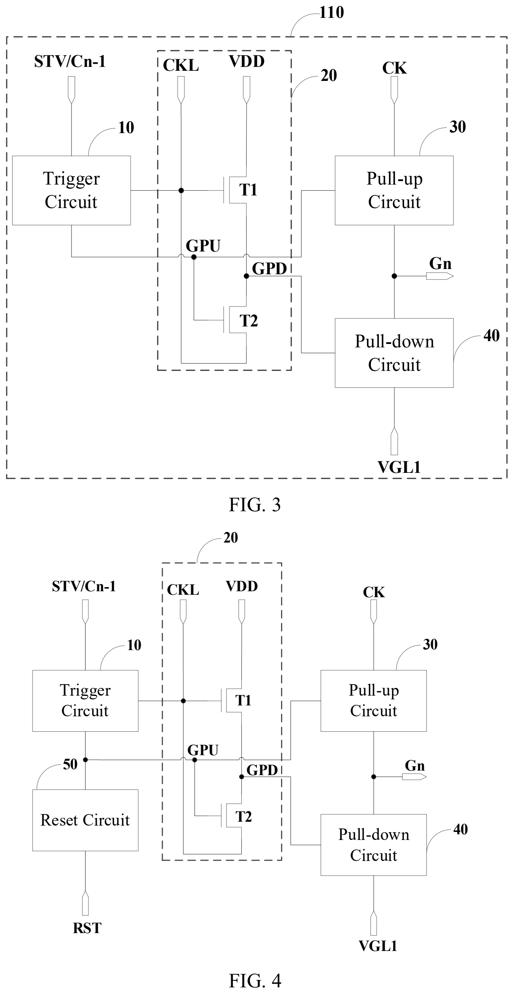

Further, to restore the GOA unit 110 to an initial state before switching between different frames, optionally, as shown in FIG. 4, optionally, the GOA driving circuit 100 is also provided with a reset circuit 50. The reset circuit 50 is in connection with the output end of the trigger circuit 10, and various circuits of the GOA unit 110 are triggered through the reset control signal RST to reset. Before the frame is switched, the GOA units 110 at all stages are reset through the reset control signal RST. The reset circuit 50 outputs a low-level signal to the pull-up circuit 30 and the inverter circuit 20, then the pull-up circuit 30, the pull-down circuit 40 and the inverter circuit 20 are reset and switched to the off state, and after the reset is completed, the start signal STV or the output signal of the GOA unit 110 at the previous stage will be received.

Herein, the trigger circuit 10, the pull-up circuit 30, the pull-down circuit 40 and the reset circuit 50 may adopt corresponding thin film transistor structures, and the specific structures are not limited.

Compared with the existing technologies, the embodiments of the present application have the following beneficial effects: the GOA driving circuit 100, as above-mentioned, includes multiple cascaded GOA units 110, each GOA unit 110 includes a trigger circuit 10, an inverter circuit 20, a pull-up circuit 30 and a pull-down circuit 40. The inverter circuit 20 includes a first thin film transistor T1 and a second thin film transistor T2. The trigger circuit 10 and the first thin film transistor T1 are switched on when the first clock signal CKL is at a high level. The voltages at two ends of the second thin film transistor T2 are both at a high level when the trigger circuit 10 outputs a high level, thus the through current of the second thin film transistor T2 is small. In case that the first clock signal CKL is at a low level, the first thin film transistor T1 is switched off and the second thin film transistor T2 also cannot form a through current, thereby the operational reliability of the GOA unit 110 is improved, which thus enhances the display reliability of the display panel 1.

### Embodiment 2

As shown in FIG. 1, when the reset circuit 50 and the trigger circuit 10 adopt a structure having a single thin film transistor, the thin film transistors at the GPU node may establish a leakage path, that is, when the GPU node is at a high level and the other end of the trigger circuit 10 and the reset circuit 50 are at a low level, a voltage difference occurs, resulting in leakage, which will causes the GPU node voltage to drop, thereby affecting the on-off output of the pull-up circuit 30.

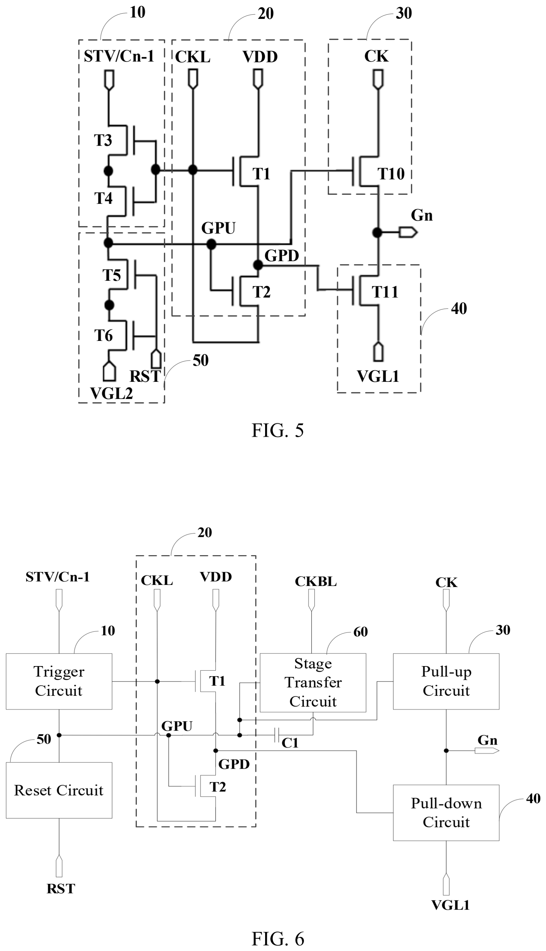

To solve this problem, as shown in FIG. 5, the trigger circuit 10 optionally includes a third thin film transistor T3 and a fourth thin film transistor T4.

A first end of the third thin film transistor T3 serves as the input end of the trigger circuit 10, a second end of the third thin film transistor T3 is in connection with a first end of the fourth thin film transistor T4, a second end of the fourth thin film transistor T4 serves as the output end of the trigger circuit 10, and a control end of the third thin film transistor T3 and a control end of the fourth thin film transistor T4 are connected in common to constitute the control end of the trigger circuit 10.

The reset circuit 50 includes a fifth thin film transistor T5 and a sixth thin film transistor T6.

A first end of the fifth thin film transistor T5 is configured to receive the second line switch-off signal VGL2, a second end of the fifth thin film transistor T5 and a first end of the sixth thin film transistor T6 are connected in common, a second end of the sixth thin film transistor T6 serves as the output end of the reset circuit 50, and a control end of the fifth thin film transistor T5 and a control end of the sixth thin film transistor T6 are connected in common to receive the reset control signal RST.

The pull-up circuit 30 includes a tenth thin film transistor T10, a first end, a second end and a control end of the tenth thin film transistor T10 respectively serve as the input end, the output end and the control end of the pull-up circuit 30.

The pull-down circuit 40 includes an eleventh thin film transistor T11, a first end, a second end and a control end of the eleventh thin film transistor T11 respectively serve as the input end, the output end and the control end of the pull-down circuit 40.

In this embodiment, the trigger circuit 10 and the reset circuit 50 are both composed of two thin film transistors connected in series. Before the frame is switched, the reset control signal RST is switched to a high level, the fifth thin film transistor T5 and the sixth thin film transistor T6 of the reset circuit 50 are switched on, and the second line switch-off signal VGL2 is output to the GPU node. The second line switch-off signal VGL2 is a low-level signal, and the low-level signal is output to the pull-up circuit 30 and the inverter circuit 20. The pull-up circuit 30, the pull-down circuit 40 and the inverter circuit 20 are reset and switched to the off state, and after the reset is completed, the start signal STV or the output signal of the GOA unit 110 at the previous stage is received.

Then, when the start signal STV or the output signal of the GOA unit 110 at the previous stage is written into a trigger waveform, the output signal of the GOA unit 110 at the previous stage may be either the scan signal Gn-1 output to the pixel units or the cascade signal Cn-1. At this time, the first clock signal CKL is at a high level, the third thin film transistor T3 and the fourth thin film transistor T4 of the trigger circuit 10 and the first thin film transistor T1 of the inverter circuit 20 are switched on, the start signal STV or the output signal of the GOA unit 110 at the previous stage is output through the trigger circuit 10. The GPU node is at a high level, and the high-level signal is output to the tenth thin film transistor T10 of the pull-up circuit 30, then the tenth thin film transistor T10 is triggered to switch on and output the second clock signal CK. The second clock signal CK is output as the output signal of the GOA unit 110 at the current stage to the GOA unit 110 at the next stage and the corresponding row of pixel units at the current stage. At this time, the voltages at two ends of the second thin film transistor T2 are both at a high level, thus, the through current of the second thin film transistor T2 is small.

Then, the first clock signal CKL is switched to a low level, the trigger circuit 10 and the first thin film transistor T1 are switched off, and the tenth thin film transistor T10 is switched off. At this time, since the first thin film transistor T1 is switched off, the second thin film transistor T2 cannot form a through current, thereby the operational reliability of the GOA unit 110 is improved, which thus enhances the display reliability of the display panel 1.

When the first clock signal CKL switches to a high level again, since the start signal STV or the output signal of the GOA unit 110 at the previous stage is written into a low-level signal, at this time, the tenth thin film transistor T10 is switched off, the first thin film transistor T1 is switched on, the second thin film transistor T2 is switched off, the signal of the GPD node is switched to the high level of the positive power supply signal VDD, the eleventh thin film transistor T11 of the pull-down circuit 40 is switched on, and the GOA unit 110 continuously outputs the first line switch-off signal VGL1.

Herein, a structure of dual thin film transistor connected in series is adopted on the leakage path of the GPU node, that is, the trigger circuit 10 and the reset circuit 50 both adopt the dual thin film transistor structure, which reduces the leakage of the GPU node, and further ensures the operational reliability of the GOA unit 110 and the display reliability of the display panel 1.

### Embodiment 3

As shown in FIG. 1, when the output signal of the pull-up circuit 30 serves as the trigger signal for the GOA unit 110 at the next stage, there is a potential risk that abnormal conditions in the pixel units of the array substrate 200 may interfere with the normal operation of the GOA unit 110. This may lead to functional anomalies in subsequent-stage GOA units 110 and failure of the cascaded driving.

To solve this problem, as shown in FIG. 6, optionally, the GOA driving circuit 100 also includes: a stage transfer circuit 60 and a bootstrap capacitor C1.

An input end of the stage transfer circuit 60 is configured to receive the third clock signal CKBL which is inverted with respect to the first clock signal CKL, an output end of the stage transfer circuit 60 is in connection with an input end of the trigger circuit 10 of the GOA unit 110 at the next stage. The stage transfer circuit 60 is triggered by the start signal STV or the output signal to switch on and output the third clock signal CKBL.

The bootstrap capacitor C1 is connected in parallel between the output end and the control end of the stage transfer circuit 60.

In this embodiment, before the frame is switched, the reset control signal RST is switched to a high level, the fifth thin film transistor T5 and the sixth thin film transistor T6 of the reset circuit 50 are switched on, and the second line switch-off signal VGL2 is output to the GPU node. The low-level signal is output to the pull-up circuit 30 and the inverter circuit 20, then the pull-up circuit 30, the pull-down circuit 40 and the inverter circuit 20 are reset and switched to the off state, and after the reset is completed, the start signal STV or the output signal of the GOA unit 110 at the previous stage is received.

Then, when the start signal STV or the output signal of the GOA unit 110 at the previous stage is written into the trigger waveform, the output signal of the GOA unit 110 at the previous stage may be the cascade signal Cn-1 at the previous stage. At this time, the first clock signal CKL is at a high level, the third thin film transistor T3 and the fourth thin film transistor T4 of the trigger circuit 10 and the first thin film transistor T1 of the inverter circuit 20 are switched on, the start signal STV or the output signal of the GOA unit 110 at the previous stage is output through the trigger circuit 10. The signal of the GPU node is at a high level, and the high-level signal is output to the tenth thin film transistor T10 of the pull-up circuit 30 and the stage transfer circuit 60. The tenth thin film transistor T10 and the stage transfer circuit 60 are triggered to switch on, and the tenth thin film transistor T10 outputs the second clock signal CK. The second clock signal CK is output as the output signal of the GOA unit 110 at the current stage to the corresponding row of pixel units at the current stage. At this time, the voltages at two ends of the second thin film transistor T2 are both at a high level, and thus the through current of the second thin film transistor T2 is small.

Then, the first clock signal CKL is switched to a low level, the trigger circuit 10 and the first thin film transistor T1 are switched off. Due to the existence of the bootstrap capacitor C1, the high level of the GPU node is stored in the bootstrap capacitor C1, and the GPU node is maintained at a high level. When the third clock signal CKBL switched to a high level, the potential of the GPU node is pulled up again through the coupling of the stage transfer circuit 60. At this time, the stage transfer circuit 60 and the pull-up circuit 30 are fully switched on, the cascade signal Cn at the current stage is output from the stage transfer circuit 60 to the trigger circuit 10 of the GOA unit 110 at the next stage, and the output signal Gn of the GOA unit 110 at the current stage is output from the pull-up circuit 30 to the corresponding row of pixel units. Similarly, since the first thin film transistor T1 is switched off, the second thin film transistor T2 cannot form a through current, which improves the operational reliability of the GOA unit 110, thereby the display reliability of the display panel 1 is further enhanced.

When the first clock signal CKL is switched to a high level again, the start signal STV or the cascade signal Cn-1 of the GOA unit 110 at the previous stage is written into a low-level signal, at this time, the tenth thin film transistor T10 is switched off, the first thin film transistor T1 is switched on, the second thin film transistor T2 is switched off, the signal of the GPD node is switched to the high level of the positive power supply signal VDD, the eleventh thin film transistor T11 of the pull-down circuit 40 is switched on, and the GOA unit 110 continuously outputs the first line switch-off signal VGL1.

By employing the stage transfer circuit 60 and the pull-up circuit 30 to distinguish the signal output of the GOA unit 110 to the GOA unit 110 at the next stage and the signal output to the pixel units, the influence of the pixel units on the signal output of the GOA unit 110 is reduced, and the operational reliability of the GOA unit 110 is improved.

Herein, the stage transfer circuit 60 may adopt a corresponding thin film transistor structure, as shown in FIG. 7, optionally, the stage transfer circuit 60 includes a seventh thin film transistor T7, an eighth thin film transistor T8 and a ninth thin film transistor T9.

A first end of the seventh thin film transistor T7 and a first end of the ninth thin film transistor T9 are connected in common to constitute the input end of the stage transfer circuit 60. A second end of the seventh thin film transistor T7, a first end of the eighth thin film transistor T8, a control end of the ninth thin film transistor T9 and a first end of the bootstrap capacitor C1 are connected in common to constitute the output end of the stage transfer circuit 60. A control end of the seventh thin film transistor T7, a second end of the bootstrap capacitor C1 and the output end of the trigger circuit 10 are connected in common. A control end of the eighth thin film transistor T8 is in connection with the output end of the inverter circuit 20, and a second end of the eighth thin film transistor T8 is configured to receive the first line switch-off signal VGL1.

In this embodiment, as shown in FIG. 8, when the start signal STV or the cascade signal Cn-1 of the GOA unit 110 at the previous stage is written into the trigger waveform, at this time, the first clock signal CKL is at a high level, the third thin film transistor T3 and the fourth thin film transistor T4 of the trigger circuit 10 and the first thin film transistor T1 of the inverter circuit 20 are switched on, the start signal STV or the cascade signal Cn-1 of the GOA unit 110 at the previous stage is output through the trigger circuit 10. The signal of the GPU node is at a high level, and the high-level signal is output to the tenth thin film transistor T10 of the pull-up circuit 30 and the seventh thin film transistor T7 and the ninth thin film transistor T9 of the stage transfer circuit 60, then the tenth thin film transistor T10, the seventh thin film transistor T7 and the ninth thin film transistor T9 are triggered to switch on, and the tenth thin film transistor T10 outputs the second clock signal CK. The second clock signal CK is output as the output signal Gn of the GOA unit 110 at the current stage to the corresponding row of pixel units at the current stage. At this time, the voltages at two ends of the second thin film transistor T2 are both at a high level, and thus the through current of the second thin film transistor T2 is small.

Then, the first clock signal CKL is switched to a low level, the trigger circuit 10 and the first thin film transistor T1 are switched off, and due to the existence of the bootstrap capacitor C1, the high level of the GPU node is stored in the bootstrap capacitor C1, the GPU node is maintained at a high level, and when the third clock signal CKBL is switched to a high level, the potential of the GPU node is pulled up again through the coupling of the seventh thin film transistor T7. At this time, the seventh thin film transistor T7 and the tenth thin film transistor T10 are fully switched on, and the stage transfer circuit 60 outputs the cascade signal Cn at the current stage to the trigger circuit 10 of the GOA unit 110 at the next stage, and the pull-up circuit 30 outputs the output signal Gn of the GOA unit 110 at the current stage to the corresponding row of pixel units, meanwhile, since a high-level signal is input to the ninth thin film transistor T9, the high-level signal is output, via the ninth thin film transistor T9, to a node where the third thin film transistor T3 and the fourth thin film transistor T4 are connected , and the high-level signal is output, via the ninth thin film transistor T9, to a node where the fifth thin film transistor T5 and the sixth thin film transistor T6 are connected, so that when the GPU node is at a high level, the node where the third thin film transistor T3 and the fourth thin film transistor T4 are connected is at a high level, and the node where the fifth thin film transistor T5 and the sixth thin film transistor T6 are connected is at a high level, thereby a source-drain potential difference between the fourth thin film transistor T4 and the fifth thin film transistor T5 is reduced, which further decreases a leakage current, and stabilizes the high-level state of the GPU node.

Similarly, since the first thin film transistor T1 is switched off, the second thin film transistor T2 cannot form a through current, thereby the operational reliability of the GOA unit 110 is improved, which thus enhances the display reliability of the display panel 1.

When the first clock signal CKL is switched to a high level again, since the start signal STV or the cascade signal Cn-1 of the GOA unit 110 at the previous stage is written into a low-level signal, at this time, the tenth thin film transistor T10 is switched off, the first thin film transistor T1 is switched on, the second thin film transistor T2 is switched off, the signal of the GPD node is switched to the high level of the positive power supply signal VDD, the eleventh thin film transistor T11 of the pull-down circuit 40 and the eighth thin film transistor T8 of the stage transfer circuit 60 are switched on, the pull-down circuit 40 continuously outputs the first line switch-off signal VGL1 to the current row of pixel units, and the stage transfer circuit 60 continuously outputs the first line switch-off signal VGL1 to the trigger circuit 10 of the GOA unit 110 at the next stage.

### Embodiment 4

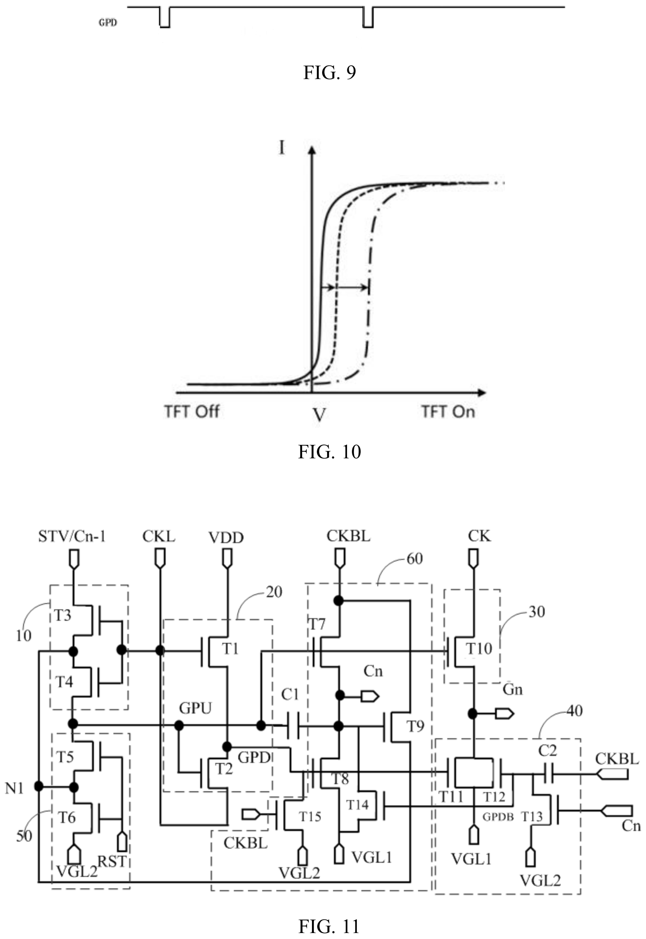

As shown in FIG. 9, during operation, during a display period of one frame, the time when the GPD node is at a low potential only accounts for 1/(number of pixel rows) of the total time. As a result, the gate electrodes of the thin-film transistors (TFTs) in the pull-down circuit 40 and/or the stage transfer circuit 60 are operated under high voltage for a long time. As shown in FIG. 7, the eighth thin-film transistor T8 and the eleventh thin-film transistor T11 have their characteristics prone to change under long-term high-voltage driving. As shown in FIG. 10, the threshold on-state voltage Vth of the thin-film transistors drifts, and the stability of the GOA unit 110 is poor.

To solve the problem that the characteristics of the thin-film transistors in the pull-down circuit 40 and/or the level shift circuit 60 change due to their prolonged operation under high voltage, optionally, as shown in FIG. 11, the pull-down circuit 40 also includes a twelfth thin film transistor T12, a thirteenth thin film transistor T13 and a coupling capacitor C2.

A first end of the coupling capacitor C2 is configured to receive the third clock signal CKBL, a second end of the coupling capacitor C2, a control end of the twelfth thin film transistor T12 and a first end of the thirteenth thin film transistor T13 are connected in common. A first end and the second end of the twelfth thin film transistor T12 are connected in parallel to the first end and the second end of the eleventh thin film transistor T11. A control end of the thirteenth thin film transistor T13 is in connection with the output end of the stage transfer circuit 60, and a second end of the thirteenth thin film transistor T13 is configured to receive the second line switch-off signal VGL2.

The stage transfer circuit 60 also includes a fourteenth thin film transistor T14 and a fifteenth thin film transistor T15.

A control end of the fourteenth thin film transistor T14 is in connection with the second end of the coupling capacitor C2, a first end and a second end of the fourteenth thin film transistor T14 are connected in parallel to the first end and the second end of the eighth thin film transistor T8, a first end of the fifteenth thin film transistor T15 is in connection with the output end of the inverter circuit 20, a second end of the fifteenth thin film transistor T15 is configured to receive the second line switch-off signal VGL2, and a control end of the fifteenth thin film transistor T15 is configured to receive the third clock signal CKBL.

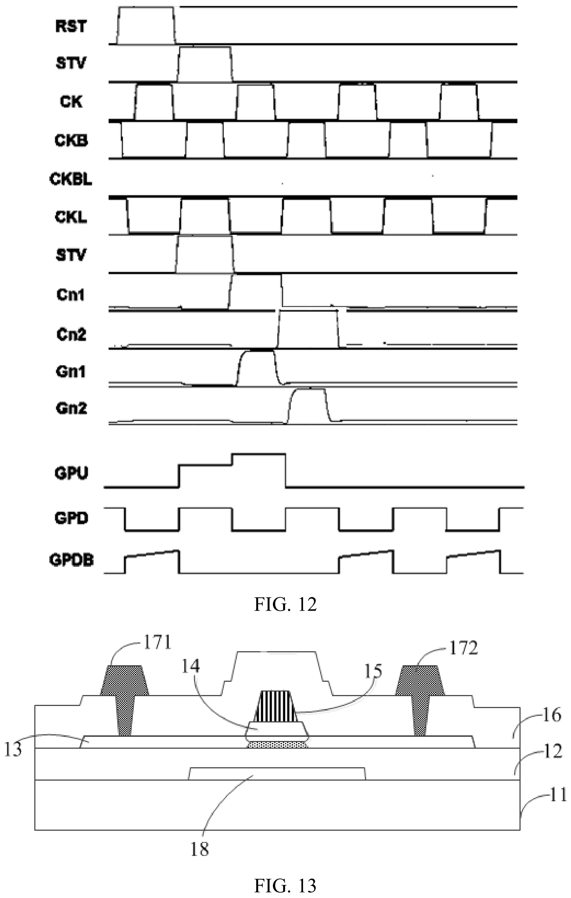

Referring to FIGS. 11 and 12, GPDB is defined as a coupling signal, and the coupling signal is a control signal output to the fourteenth thin film transistor T14 and the twelfth thin film transistor T12. In a first time period, RST controls an input of the second line switch-off signal VGL2 to reset the GOA units 110 at all stages.

In a second time period, the start signal STV or the cascade signal Cn-1 output from the GOA unit 110 at the previous stage is written into the trigger waveform. At this time, the first clock signal CKL is at a high level, the third thin film transistor T3 and the fourth thin film transistor T4 are switched on, and the start signal STV or the cascade signal Cn-1 output from the GOA unit 110 at the previous stage is written into the GPU node. Then, the second thin film transistor T2 is controlled via the GPU to write the first clock signal CKL into the GPD node, and the GPD node is set to a high level. Since the third clock signal CKBL is set to a low level, the GPDB is set to a low level through the coupling capacitor C2, and the twelfth thin film transistor T12 and the fourteenth thin film transistor T14 are switched off. Since the third clock signal CKBL is a low-level signal at this time, the fifteenth thin film transistor T15 is switched off, and the eighth thin film transistor T8 is switched on and outputs a low-level signal.

In a third time period, the first clock signal CKL is switched to a low level, and the high level of the GPU node is stored in the bootstrap capacitor C1, and is maintained until the third clock signal CKBL is switched to a high potential. Through the coupling of the seventh thin film transistor T7, the potential of the GPU node is pulled up again. At this time, the seventh thin film transistor T7 and the tenth thin film transistor T10 are fully switched on, and the GOA unit 110 outputs Cn and Gn, which are respectively the high potentials of the third clock signal CKBL and the second clock signal CK.

At this time, the fifteenth thin film transistor T15 is controlled via the third clock signal CKBL to switch on, and the second line switch-off signal VGL2 is written at the GPD node, while the first line switch-off signal VGL1 is written at the GPDB as the thirteenth thin film transistor T13 is controlled via Cn to switch on, to ensure that the pull-down circuit 40 has no output.

In a fourth time period, when the first clock signal CKL is switched to a high level again, since a low potential of the start signal STV or the cascade signal Cn-1 output from the GOA unit 110 at the previous stage is written into the GPU, the seventh thin film transistor T7 and the tenth thin film transistor T10 are switched off, the second thin film transistor T2 is switched off, the first thin film transistor T1 is switched on. The positive power supply signal VDD is written to the GPD node, the eighth thin film transistor T8 and the eleventh thin film transistor T11 are controlled to be switched on, and the first line switch-off signal VGL1 is output from Cn and Gn.

At this time, the third clock signal CKBL is at a low level, and the GPDB voltage is set to a low level through the coupling capacitor C2, and the fourteenth thin film transistor T14 and the twelfth thin film transistor T12 are switched off.

In a fifth time period, when the first clock signal CKL is switched to a low level, the fifteenth thin film transistor T15 is controlled via the third clock signal CKBL to switch on, the low potential of the second line switch-off signal VGL2 is written to the GPD node, the eighth thin film transistor T8 and the eleventh thin film transistor T11 are switched off, the GPDB voltage is set to a high level through the third clock signal CKBL and the coupling capacitor C2, the fourteenth thin film transistor T14 and the twelfth thin film transistor T12 are switched on, and the first line switch-off signal VGL1 is output from Cn and Gn.

Before the next frame is initialized and reset, the fourth time period and the fifth time period are repeated cyclically.

That is, during a period when the stage transfer circuit 60 and the pull-down circuit 40 continue to output low-level signals, the eighth thin film transistor T8 and the fourteenth thin film transistor T14 are alternately switched on and off, and the eleventh thin film transistor T11 and the twelfth thin film transistor T12 are alternately switched on and off, and the voltage at the control end is switched to a changing pulse signal instead of a continuous high-level signal, which improves the characteristic drift problem of the long-term bias voltage of the thin film transistor and improves the stability of the long-term operation of the GOA unit 110.

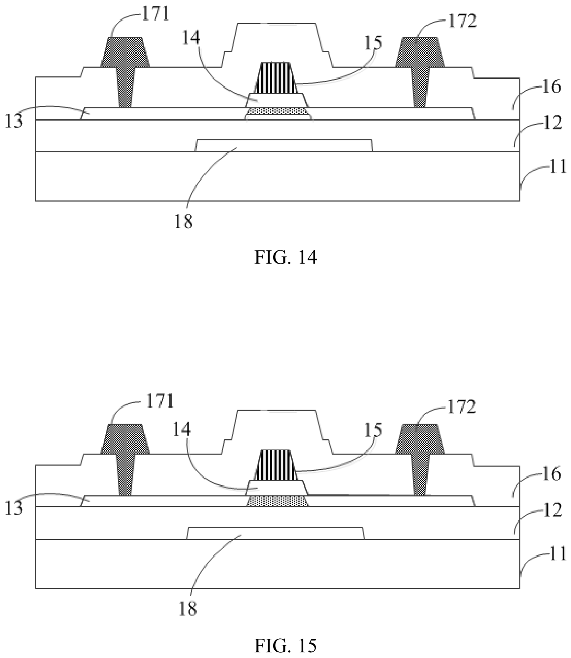

As shown in FIGS. 13 to 15, the thin film transistor includes a substrate 11, a bottom gate layer 18, a buffer layer 12, an active layer 13, a gate insulating layer 14, a top gate layer 15, an interlayer insulating layer 16, a source 171 and a drain 172 that are vertically stacked. As shown in FIG. 13, a top channel of a channel region of the active layer 13 is switched on when a high level is applied to the top gate layer 15 and a low level is applied to the bottom gate layer 18. As shown in FIG. 14, a bottom channel of the channel region of the active layer 13 is switched on when a high level is applied to the bottom gate layer 18 and a low level is applied to the top gate layer 15. And as shown in FIG. 15, when the bottom gate layer 18 and the top gate layer 15 are both connected to a low level, no channel is formed.

By switching the high and low levels to change the states of top gate being switched on and bottom gate being switched on, the problem of device drift caused by carriers being captured by interface defects of the active layer 13 or the gate insulating layer 14 and internal defects of the gate insulating layer 14 when the thin film transistor is in the state of top gate being switched on for a long time can be avoided.

Meanwhile, when the bottom gate is switched on, the negative pressure of the top gate will excite the carriers captured in the defects, which plays a role in resetting the threshold voltage.

### Embodiment 5

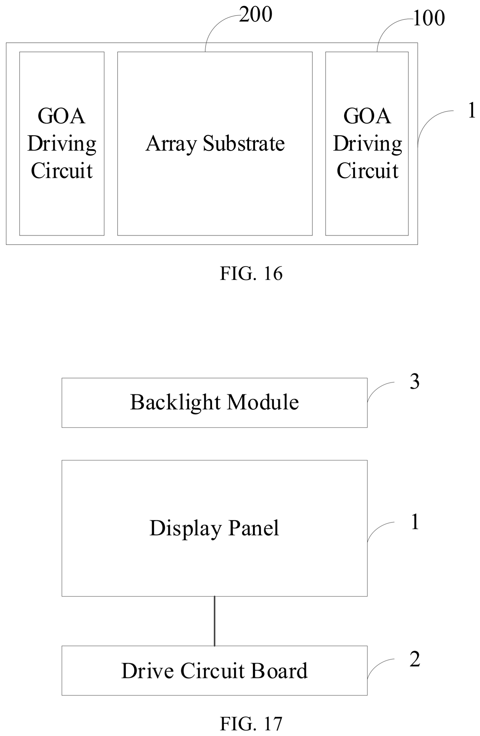

The present application also provides a display panel 1, as shown in FIG. 16, the display panel 1 includes an array substrate 200 and a GOA driving circuit 100. The specific structure of the GOA driving circuit 100 refers to the above embodiment. Since all the technical schemes of all the above embodiments are adopted by the display panel 1, the display panel 1 here at least has all the beneficial effects brought by the technical schemes of the above embodiments, which thus will not be repeated here. In this embodiment, the GOA driving circuit 100 is arranged on one side or two sides of the array substrate 200.

In this embodiment, the array substrate 200 includes a display area and a non-display area, and the non-display area is provided with a binding pin area and the GOA driving circuit 100. The GOA driving circuit 100 is arranged on one side or two sides of the non-display area of the array substrate 200 for line-by-line scanning of the display area, and cooperates with the data signal to realize the line-by-line scanning drive of the display area.

### Embodiment 6

The present application also provides a display device, as shown in FIG. 17, which includes a backlight module 3, a drive circuit board 2 and a display panel 1. The specific structure of the display panel 1 may refer to the above embodiment. Since all the technical solutions of all the above embodiments are applied in the display device, the display device at least has all the beneficial effects brought by the technical solutions of the above embodiments, which thus will not be described one by one here. Herein, the backlight module 3 and the display panel 1 are arranged opposite to each other, and the drive circuit board 2 is electrically connected to the display panel 1.

In this embodiment, the backlight module 3 is configured to provide backlight, the drive circuit board 2 is connected to the display panel 1 through the chip-on-chip film, and an external control signal is input to a driving chip in the chip-on-chip film. The driving chip converts the external control signal into a data signal and a control signal required for the GOA driving circuit 100 to drive. The GOA driving circuit 100 converts and outputs a shift pulse signal of a multi-channel sub-row scan signal, and cooperates with the data signal to realize the line-by-line scanning drive of the display area.

The embodiments described above are only used to illustrate, rather than limit, the technical solutions of the present application. Although the present application has been described in detail with reference to the aforementioned embodiments, a person skilled in the art should understand that the technical solutions described in the aforementioned embodiments may still be modified, or some of the technical features may be replaced by equivalents. Such modifications or replacements do not deviate the essence of the corresponding technical solutions from the spirit and scope of the technical solutions of the embodiments of the present application, and thus should all be included within the protection scope of the present application.

## Claims

1. A GOA driving circuit, comprising multiple cascaded GOA units, each GOA unit comprising:
a trigger circuit, wherein an input end of the trigger circuit is configured to receive a start signal or an output signal of a GOA unit at a previous stage, a control end of the trigger circuit is configured to receive a first clock signal, the trigger circuit is triggered to switch on and output the start signal or the output signal when the first clock signal is at a high level, and is triggered to switch off when the first clock signal is at a low level;
a pull-up circuit, wherein an input end of the pull-up circuit is configured to receive a second clock signal, an output end of the pull-up circuit serves as a signal output end of the GOA unit, a control end of the pull-up circuit is in connection with an output end of the trigger circuit, the pull-up circuit is triggered by the start signal or the output signal to switch on and output the second clock signal;
an inverter circuit, comprising a first thin film transistor and a second thin film transistor, wherein a first end of the first thin film transistor is connected to a positive power supply terminal, a control end of the first thin film transistor and a second end of the second thin film transistor are configured to receive the first clock signal, a second end of the first thin film transistor and a first end of the second thin film transistor are connected in common to constitute an output end of the inverter circuit, a control end of the second thin film transistor is in connection with the output end of the trigger circuit, the first thin film transistor and the second thin film transistor are triggered by a high-level signal to switch on and triggered by a low-level signal to switch off; and
a pull-down circuit, wherein an input end of the pull-down circuit is configured to receive a first line switch-off signal, an output end of the pull-down circuit is in connection with the output end of the pull-up circuit, a control end of the pull-down circuit is in connection with the output end of the inverter circuit, and the pull-down circuit is triggered by a high-level signal to switch on.

2. The GOA driving circuit as claimed in claim 1, wherein the GOA units at multiple stages are respectively connected to corresponding scan lines of an array substrate, the scan lines at multiple stages are connected to multiple rows of pixel units on the array substrate respectively, and the GOA units at multiple stages output line switch-on signals and line switch-off signals to the multiple rows of pixel units row by row.

3. The GOA driving circuit as claimed in claim 1, wherein the first thin film transistor and the second thin film transistor are N-channel thin film transistors.

4. The GOA driving circuit as claimed in claim 1, wherein the trigger circuit comprises a third thin film transistor and a fourth thin film transistor; and
a first end of the third thin film transistor serves as the input end of the trigger circuit, a second end of the third thin film transistor is in connection with a first end of the fourth thin film transistor, a second end of the fourth thin film transistor serves as the output end of the trigger circuit, and a control end of the third thin film transistor and a control end of the fourth thin film transistor are connected in common to constitute the control end of the trigger circuit.

5. The GOA driving circuit as claimed in claim 4, wherein the GOA driving circuit further comprises:
a reset circuit which is in connection with the output end of the trigger circuit and is triggered by a reset control signal to reset each circuit of the GOA unit;
the reset circuit comprises a fifth thin film transistor and a sixth thin film transistor; and
a first end of the fifth thin film transistor is configured to receive a second line switch-off signal, a second end of the fifth thin film transistor and a first end of the sixth thin film transistor are connected in common, a second end of the sixth thin film transistor serves as an output end of the reset circuit, and a control end of the fifth thin film transistor and a control end of the sixth thin film transistor are connected in common to receive the reset control signal.

6. The GOA driving circuit as claimed in claim 5, wherein the first line switch-off signal and the second line switch-off signal are low-level signals.

7. The GOA driving circuit as claimed in claim 5, wherein the GOA driving circuit further comprises:
a stage transfer circuit, wherein an input end of the stage transfer circuit is configured to receive a third clock signal that is inverted from the first clock signal, an output end of the stage transfer circuit is in connection with the input end of the trigger circuit of a GOA unit at a next stage, a control end of the stage transfer circuit is in connection with the output end of the trigger circuit, and the stage transfer circuit is triggered by the high-level signal output from the trigger circuit to switch on and output the third clock signal; and
a bootstrap capacitor, wherein the bootstrap capacitor is connected in parallel between the output end and the control end of the stage transfer circuit.

8. The GOA driving circuit as claimed in claim 7, wherein the stage transfer circuit comprises a seventh thin film transistor, an eighth thin film transistor and a ninth thin film transistor; and
a first end of the seventh thin film transistor and a first end of the ninth thin film transistor are connected in common to constitute the input end of the stage transfer circuit, a second end of the seventh thin film transistor, a first end of the eighth thin film transistor, a control end of the ninth thin film transistor and a first end of the bootstrap capacitor are connected in common to constitute the output end of the stage transfer circuit, a control end of the seventh thin film transistor, a second end of the bootstrap capacitor and the output end of the trigger circuit are connected in common, a control end of the eighth thin film transistor is in connection with the output end of the inverter circuit, a second end of the eighth thin film transistor is configured to receive the first line switch-off signal, a second end of the ninth thin film transistor, the second end of the third thin film transistor and the first end of the fourth thin film transistor are connected in common.

9. The GOA driving circuit as claimed in claim 8, wherein the pull-up circuit comprises a tenth thin film transistor, a first end, a second end and a control end of the tenth thin film transistor respectively serve as the input end, the output end and the control end of the pull-up circuit; and
the pull-down circuit comprises an eleventh thin film transistor, a first end, a second end and a control end of the eleventh thin film transistor respectively serve as the input end, the output end and the control end of the pull-down circuit.

10. The GOA driving circuit as claimed in claim 9, wherein the pull-down circuit further comprises a twelfth thin film transistor, a thirteenth thin film transistor and a coupling capacitor; and
a first end of the coupling capacitor is configured to receive the third clock signal, a second end of the coupling capacitor, a control end of the twelfth thin film transistor and a first end of the thirteenth thin film transistor are connected in common, a first end and a second end of the twelfth thin film transistor are respectively connected in parallel to the first end and the second end of the eleventh thin film transistor, a control end of the thirteenth thin film transistor is in connection with the output end of the stage transfer circuit, and a second end of the thirteenth thin film transistor is configured to receive the second line switch-off signal.

11. The GOA driving circuit as claimed in claim 10, wherein the stage transfer circuit further comprises a fourteenth thin film transistor and a fifteenth thin film transistor; and
a control end of the fourteenth thin film transistor is in connection with a second end of the coupling capacitor, a first end and a second end of the fourteenth thin film transistor are respectively connected in parallel to the first end and the second end of the eighth thin film transistor, a first end of the fifteenth thin film transistor is in connection with the output end of the inverter circuit, a second end of the fifteenth thin film transistor is configured to receive the second line switch-off signal, and a control end of the fifteenth thin film transistor is configured to receive the third clock signal.

12. The GOA driving circuit as claimed in claim 11, wherein during a period when the stage transfer circuit and the pull-down circuit continuously output low-level signals, the eighth thin film transistor and the fourteenth thin film transistor are alternately switched on and off, and the eleventh thin film transistor and the twelfth thin film transistor are alternately switched on and off.

13. A display panel, comprising an array substrate and the GOA driving circuit as claimed in claim 1, wherein the GOA driving circuit is arranged on one side or both sides of the array substrate.

14. A display device, comprising a backlight module, a drive circuit board and the display panel as claimed in claim 13, wherein the backlight module and the display panel are arranged opposite to each other, and the drive circuit board is electrically connected to the display panel.

15. The display device as claimed in claim 14, wherein the backlight module is configured to provide backlight, the drive circuit board is connected to the display panel through a chip-on-chip film, and an external control signal is input to a driving chip in the chip-on-chip film, and the external control signal is converted by the driving chip into a data signal and a control signal required for driving the GOA driving circuit.
